# EUROPEAN PATENT SPECIFICATION

(11) **EP 4 564 425 B1**
(45) Date of publication and mention of the grant of the patent: **19.08.2026**
(21) Application number: 24215550.5
(22) Date of filing: 26.11.2024
(51) Int. Cl.: H10W 70/40, H10W 42/00, H10W 74/01, H10W 74/10, H10W 90/00

(54) **ELECTRONIC PACKAGE WITH A BATTERY SECURED BY A BENT LEADFRAME**
ELEKTRONISCHES GEHÄUSE MIT EINER BATTERIE, DIE DURCH EINEN GEBOGENEN LEITERRAHMEN BEFESTIGT IST
BOÎTIER ÉLECTRONIQUE AVEC UNE BATTERIE SÉCURISÉE PAR UNE GRILLE DE CONNEXION PLIÉE

(30) Priority: 28.11.2023 US 202318521895
(43) Date of publication of application: 04.06.2025
(73) Proprietor: NXP USA, Inc., Austin, TX 78735 (US)
(72) Inventor: KANTH, Namrata, 5656 AG Eindhoven (NL); SHADE, Douglas Michael, 5656 AG Eindhoven (NL); HAYES, Scott M., 5656 AG Eindhoven (NL); HOOPER, Stephen Ryan, 5656 AG Eindhoven (NL); LICTAO Jr., Crispulo Estira, 5656 AG Eindhoven (NL); FLICK, Mollie, 5656 AG Eindhoven (NL); YOUNGBLOOD Jr., Alvin Lee, 5656 AG Eindhoven (NL); ARLDT, Roy Lynn, 5656 AG Eindhoven (NL)
(74) Representative: Colaiuda, Antonella

(56) References cited:
- EP-A1- 4 379 796
- EP-A2- 0 460 801
- EP-A2- 0 605 987
- JP-A- 2003 273 311
- US-A- 4 075 825
- US-A- 4 202 166
- US-A- 4 998 888

## Description

### FIELD OF THE INVENTION

The invention relates generally to packaging of electronic components. In particular, the invention relates to an electronic package with a battery.

### BACKGROUND

Some electronic components are packaged with batteries to provide power to the integrated circuitry contained in the electronic components. In some packages, molded battery holders are used to secure the batteries onto the underlying structures, which may include dies and other electronic components. US4998888A, EP0605987A2, EP0460801A2, US4075825A and US4202166A each disclose an integrated circuit package with a battery.

### SUMMARY

An electronic package with a battery and method for producing the electronic package uses a bent leadframe having flanged ends that are physically and electrically connected to a substrate so that the battery is encircled by the bent leadframe and the substrate, and the substrate is positioned between the battery and an electronic component. A first terminal of the battery is physically and electrically connected to the substrate and a second terminal of the battery is physically and electrically connected to the bent leadframe, which provides an electrical connection between the battery and the electronic component.

In an embodiment, an electronic package comprises a substrate with an electronic component, a battery having a first terminal that is physically and electrically connected to the substrate, and a bent leadframe having flanged ends that are physically and electrically connected to the substrate so that the battery is encircled by the bent leadframe and the substrate and the substrate is positioned between the battery and the electronic component, the bent leadframe further being physically and electrically connected to a second terminal of the battery to provide an electrical connection between the battery and the electronic component through the bent leadframe.

In an embodiment, the first terminal of the battery is welded to the bent leadframe or attached to the bent leadframe using an electrically conductive adhesive or solder.

In an embodiment, the first terminal of the battery is the positive terminal of the battery.

In an embodiment, the second terminal of the battery is attached to the substrate using an electrically conductive adhesive or solder.

In an embodiment, the second terminal of the battery is the negative terminal of the battery.

In an embodiment, at least one of the flanged ends of the bent leadframe is welded to the substrate or attached to the substrate using an electrically conductive adhesive or solder.

In an embodiment, the battery is a coin-type battery.

In an embodiment, the substrate is a leadframe and wherein the electronic component is a die attached to a leadframe.

In an embodiment, the electronic component is a die attached to the substrate.

In an embodiment, the die is attached to the substrate faced down such that a side of the die with input and output connections is facing the substrate or faced up such that the side with the input and output connections of the dies is facing away from the substrate.

In an embodiment, a method for producing an electronic package comprises providing a substrate with an electronic component, attaching a battery to the substrate such that a first terminal of the battery is physically and electrically connected to the substrate, and attaching a bent leadframe to the substrate such that flanged ends of the bent leadframe are physically and electrically connected to the substrate so that the battery is encircled by the bent leadframe and the substrate, and the substrate is positioned between the battery and the electronic component, including attaching the bent leadframe to the battery so that the bent leadframe is physically and electrically connected to a second terminal of the battery to provide an electrical connection between the battery and the electronic component through the bent leadframe.

In an embodiment, the first terminal of the battery is welded to the bent leadframe or attached to the bent leadframe using an electrically conductive adhesive or solder.

In an embodiment, the first terminal of the battery is the positive terminal of the battery.

In an embodiment, the second terminal of the battery is attached to the substrate using an electrically conductive adhesive or solder.

In an embodiment, the second terminal of the battery is the negative terminal of the battery.

In an embodiment, at least one of the flanged ends of the bent leadframe is welded to the substrate or attached to the substrate using an electrically conductive adhesive or solder.

In an embodiment, an electronic package comprises a substrate having first and second surfaces, an electronic component attached to the first surface of the substrate, a battery having a first terminal that is physically and electrically connected to the second surface of the substrate, and a bent leadframe having flanged ends that contact the second surface of the substrate so that the battery is encircled by the bent leadframe and the substrate and the substrate is positioned between the battery and the electronic component, the bent leadframe being further in contact with a second terminal of the battery to provide an electrical connection between the battery and the electronic component through the bent leadframe.

In an embodiment, the first terminal of the battery is welded to the bent leadframe or attached to the bent leadframe using an electrically conductive adhesive or solder.

In an embodiment, the second terminal of the battery is attached to the second surface of the substrate using an electrically conductive adhesive or solder.

In an embodiment, at least one of the flanged ends of the bent leadframe is welded to the second surface of the substrate or attached to the second surface of the substrate using an electrically conductive adhesive or solder.

These and other aspects in accordance with embodiments will become apparent from the following detailed description, taken in conjunction with the accompanying drawings, illustrated by way of example of the principles of the embodiments.

### BRIEF DESCRIPTION OF THE DRAWINGS

Fig. 1 depicts an electronic package with a battery and a leadframe-based package structure in accordance with an embodiment of the invention.
Figs. 2A-2H illustrate a process of producing the electronic package of Fig. 1 in batches in accordance with an embodiment of the invention.
Fig. 3 depicts an electronic package with a battery and a package structure in accordance with a different embodiment of the invention.
Fig. 4 depicts an electronic package with a battery and a flip chip package structure in accordance with an embodiment of the invention.
Fig. 5 depicts an electronic package with a battery and a package structure in accordance with another embodiment of the invention.
Fig. 6 shows a flow diagram of a method for producing an electronic package, such as the electronic packages depicted in Figs. 1 and 3-5, in accordance with an embodiment of the invention.

Throughout the description, similar reference numbers may be used to identify similar elements.

### DETAILED DESCRIPTION

A concern with the molded battery holders used in conventional electronic packages is that the battery holders may cause the batteries to experience high temperatures, which may significantly degrade the performance of the batteries. In addition, the batteries can expand and swell over time, which can damage the molded battery holders and other components in the packages. Furthermore, the batteries are typically mounted on printed circuit boards next to packaged components, which can increase overall size and cost of the packages. Lastly, conventional packages with batteries may have limitations with respect to the number of components that can be packaged together.

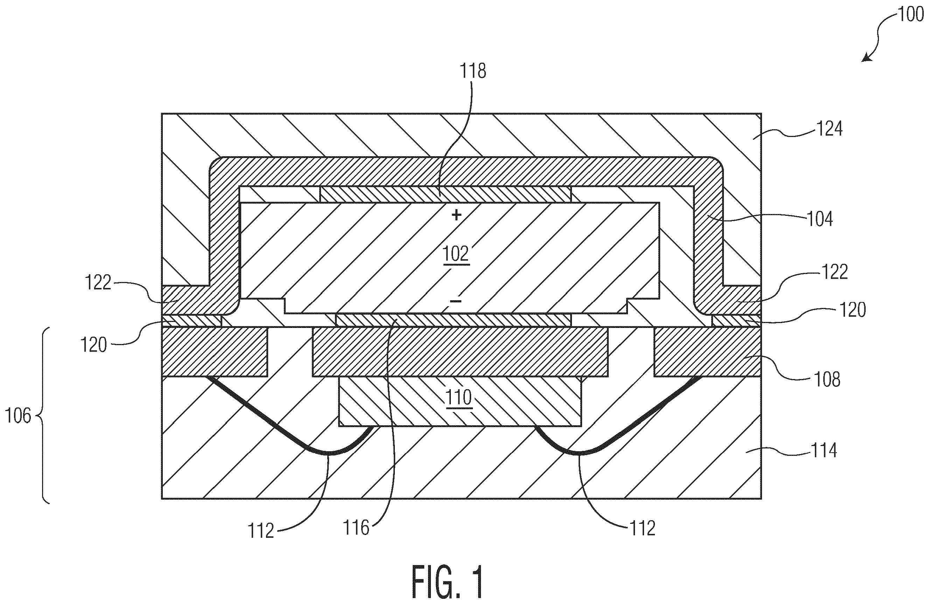

Accordingly, embodiments described herein can have advantages over previous approaches used in electronic packages with batteries. Fig. 1 depicts an electronic package 100 with a battery 102 in accordance with an embodiment of the invention that addresses at least some of the concerns described above with respect to conventional electronic packages with molded battery holders. As shown in Fig. 1, the electronic package uses a bent leadframe 104 to encircle the battery that is attached to a package structure 106 in a compact form factor in order to secure the battery as well as to provide an electrical connection between the battery and at least one electronic component of the package structure. The electronic package 100 may be fabricated without exposing the battery to high temperatures, which can damage the battery. The electronic package 100 can be used for a low-power integrated circuit device commonly found in consumer, home and industrial spaces that is powered by a battery. The electronic package 100 may be used for various applications, such as tire pressure monitoring, smart home monitoring (e.g., garage sensors, alarms and smoke detectors) and asset tracking.

In this embodiment, the package structure 106 is a leadframe-based package structure. Thus, the package structure 106 includes a substrate in the form of a leadframe 108 on which a die 110 is attached. The die 110 can be any type of die with integrated circuits fabricated on or within semiconductor material. The die 110 is physically attached to the leadframe 108 using a bonding material. Non-limiting examples of suitable bonding materials according to embodiments herein include adhesive bonding materials such as epoxy or other adhesives and metallurgical bonding materials such as solders, which can include eutectic solders. The die 110 is also electrically connected to the leadframe. In this embodiment, bondwires 112 are used to electrically connect the die 110 to the leadframe 108. At least two of these bondwires 112 are used to electrically connect the die 110 to a first terminal (positive or negative) and a second terminal (negative or positive) of the battery 102, as described below. In other embodiments, the package structure 106 may include more than one die, e.g., stacked die, and other electronic components, e.g., surface mount device (SMD) components, attached to the leadframe 108. In the illustrated embodiment, the die 110 is encapsulated using an appropriate encapsulant material 114, such as epoxy encapsulants. However, in other embodiments, the die 110 may not be encapsulated.

The battery 102 is attached to the leadframe 108 of the package structure 106 such that the leadframe 108 is sandwiched between the battery 102 and the die 110. In the illustrated embodiment, the battery 102 is a non-rechargeable coin-type battery with a positive side as the first terminal and a negative side as the second terminal. However, the battery 102 can be any type of battery, such as a button-type battery. The negative side of the battery 102 in the illustrated embodiment is physically attached to the leadframe 108 using a bonding process, which also provides an electrical connection between the negative side of the battery to the leadframe 108 of the package structure 106. As used herein, the bonding process includes, but is not limited to, an adhesive bonding process using a low temperature cure electrically conductive adhesive (ECA) or a metallurgical bonding process such as a soldering process or a welding process. In one or more embodiments, a welding process involves application of heat and pressure to create a bond between two contacting surfaces without an intervening bonding material. As an example, the welding process may be a laser spot welding process. However, welding processes may not be possible on buried surfaces because a probe tool for contacting two faces may be needed to facilitate welding. Thus, in the illustrated embodiment, the negative side of the battery 102 is physically attached to the leadframe 108 using an electrically conductive bonding material 116, such as ECA or solder, assuming that welding is not used for this bonding.

The positive side of the battery 102 is physically attached to the bent leadframe 104 using another bonding process, which also provides an electrical connection between the positive side of the battery to the leadframe of the package structure through the bent leadframe. The bonding process used to attach the positive side of the battery to the bent leadframe may be the same bonding process that is used to attach the negative side of the battery 102 to the leadframe 108, or a different bonding process, such as a welding process. In the illustrated embodiment, the positive side of the battery 102 is physically attached to the bent leadframe 104 using an electrically conductive bonding material 118, such as ECA or solder. However, if a welding process was used to attach the positive side of the battery 102 to the bent leadframe 104, there may be no bonding material between the positive side of the battery 102 and the bent leadframe 104.

In one or more embodiments, the electrically conductive bonding material 118 may be the same material as the electrically conductive bonding material 116. Thus, in these embodiments, both of the electrically conductive bonding materials 116 and 118 may be a low temperature cure ECA, or both of the electrically conductive bonding materials 116 and 118 may be a low temperature solder. In other embodiments, the electrically conductive material 116 may be a different material from the electrically conductive bonding material 118. Thus, in these embodiments, one of the electrically conductive materials 116 and 118 may be a low temperature cure ECA and the other electrically conductive material may be a low temperature solder.

As shown in Fig. 1, the bent leadframe 104 is also attached to the leadframe 108. In the illustrated embodiment, the bent leadframe 104 has flanged ends 122 that are attached to the leadframe 108 using another bonding process, which also provides an electrical connection between the flanged ends 122 of the bent leadframe 104 to the leadframe 108 of the package structure. The bonding process used to attach the flanged ends 122 of the bent leadframe 104 to the leadframe 108 may be the same bonding process that is used to attach the negative side of the battery 102 to the leadframe 108, or a different bonding process, such as a welding process. In the illustrated embodiment, the flanged ends 122 of the bent leadframe 104 are attached to the leadframe 108 using an electrically conductive bonding material 120, such as ECA or solder. However, if a welding process was used to attach the flanged ends 122 of the bent leadframe 104 to the leadframe 108, there may be no bonding material between the flanged ends 122 of the bent leadframe 104 and the leadframe 108.

As illustrated in Fig. 1, the main portion of the bent leadframe 104 between the flanged ends 122 is shaped so that the battery 102 is encircled by the bent leadframe 104 and the leadframe 108. Thus, the bent leadframe 104 may be shaped to correspond to the profile of the battery 102 when the flanged ends 122 of the bent leadframes are attached to the leadframe 108. In one or more embodiments, the same or different electrically conductive bonding materials may be used to attach the two flanged ends 122 of the bent leadframe 104 to the leadframe 108. The bent leadframe 104 may be made of material commonly used for leadframes, such as copper, copper alloy or iron-nickel alloy.

The bent leadframe 104 provides structural support to secure the battery 102 for the electronic package 100. In addition, the bent leadframe 104 provides an electrical connection between the positive side of the battery 102 to the die 110 through the leadframe 108 and one of the bondwires 112. The negative side of the battery 102 is connected to the die through the leadframe 108 and another bondwire 112. Thus, the bent leadframe 104 provides an efficient mechanism for structural support of the battery 102 and for electrical connection between the battery 102 and the die 110.

In the illustrated embodiment, the bent leadframe 104 and the battery 102 is encapsulated using a potting material 124 or conformal coating. Low temperature cure is preferred to minimize battery performance deficit. For automotive products subjected to vibrations, a sturdy encapsulant may be required to hold the battery in place. For consumer and home applications, a thin coating for electrical isolation of the system may be sufficient. However, in other embodiments, the bent leadframe 104 and the battery 102 may not be encapsulated.

In the illustrated embodiment, the battery 102 is orientated such that the positive side of the battery is attached to the bent leadframe 104 and the negative side of the battery is attached to the leadframe 108. However, in other embodiments, the orientation of the battery 102 may be flipped such that the negative side of the battery is attached to the bent leadframe 104 and the positive side of the battery is attached to the leadframe 108.

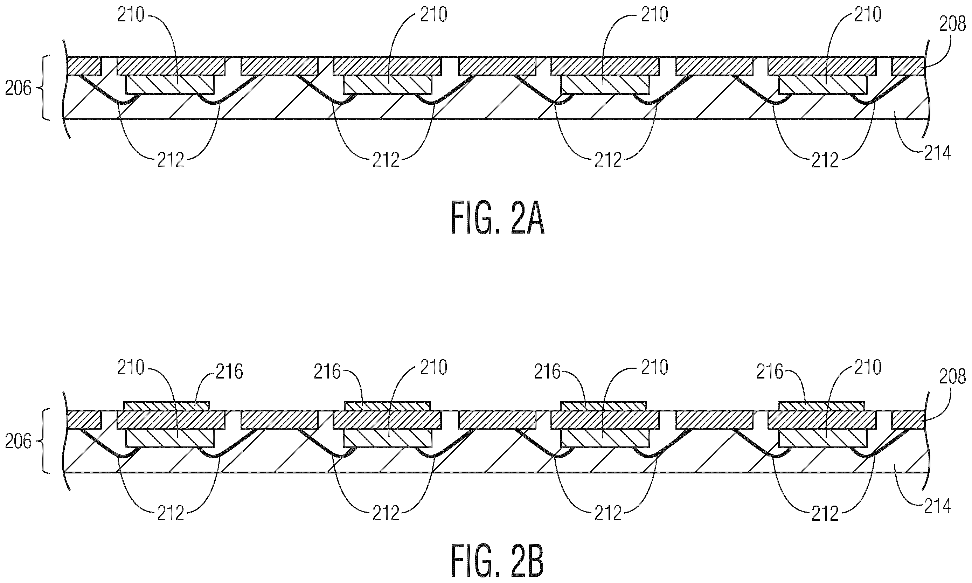

In one or more embodiments, the electronic package 100 may be produced in batches. Figs. 2A-2K illustrate a process of producing a batch of electronic packages in accordance with an embodiment of the invention.

The process begins by fabricating a package structure 206 with multiple dies 210 mounted on a leadframe 208, as illustrated in Fig. 2A. In the illustrated embodiment, each die 210 is electrically connected to the leadframe 208 by bondwires 212. The package structure 206 may be fabricated using one or more known fabrication machines that execute known packaging processes. As an example, the dies 210 may be first attached to the leadframe 208 using a bonding material, such as epoxy, eutectic material or solder. The attached dies 210 are then wire bonded to the leadframe 208 using wires to form the bondwires 212. The attached dies 210 with the bondwires 212 may then be encapsulated using an epoxy-based mold compound 214.

Next, an electrically conductive bonding material 216 is selectively placed on the leadframe 208 of the package structure 206 for attaching batteries 202 to the leadframe 208, as illustrated in Fig. 2B. The electrically conductive bonding material 216 may be any electrically conductive material that can be used as a bonding material, such as a low temperature cure ECA or low temperature solder.

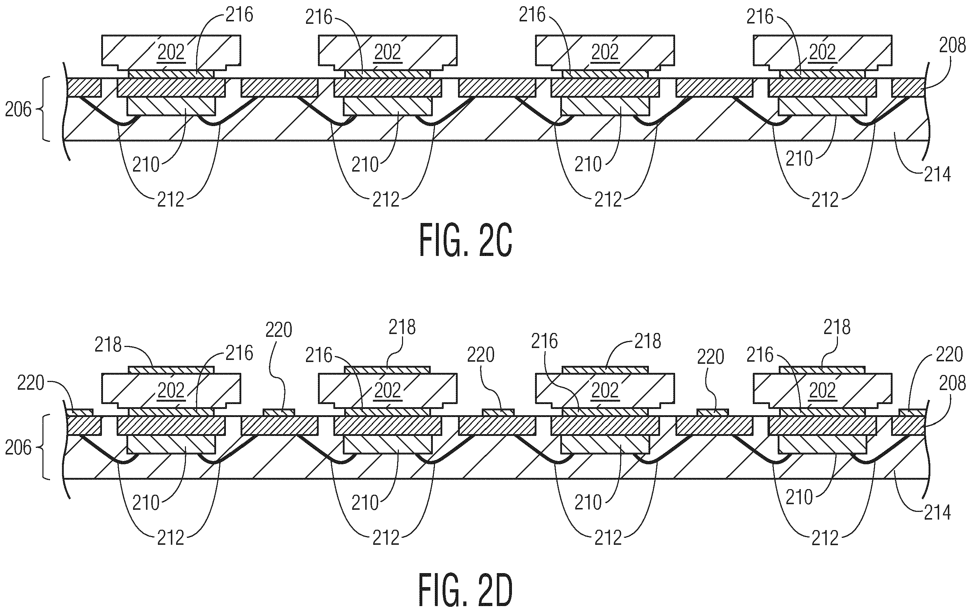

Next, the batteries 202 are attached to the leadframe 208 of the package structure 206 using the electrically conductive bonding material 216 applied to the leadframe 208 such that the negative sides (or positive sides) of the batteries are physically attached and electrically connected to the leadframe 208, as illustrated in Fig. 2C. In an alternative embodiment, the electrically conductive bonding material 216 may be applied to the batteries 202 before the batteries 202 are attached to the leadframe 208. In other embodiments,

Next, an electrically conductive bonding material 218 is applied to the positive sides (or negative sides) of the batteries 202 for attaching a bent leadframe 204 to the batteries, as illustrated in Fig. 2D. In addition, an electrically conductive bonding material 220 is applied to the leadframe 208 for attaching the bent leadframe 204 to the leadframe 208. The electrically conductive bonding materials 218 and 220 may be any electrically conductive material that can be used as a bonding material, such as a low temperature cure ECA or low temperature solder.

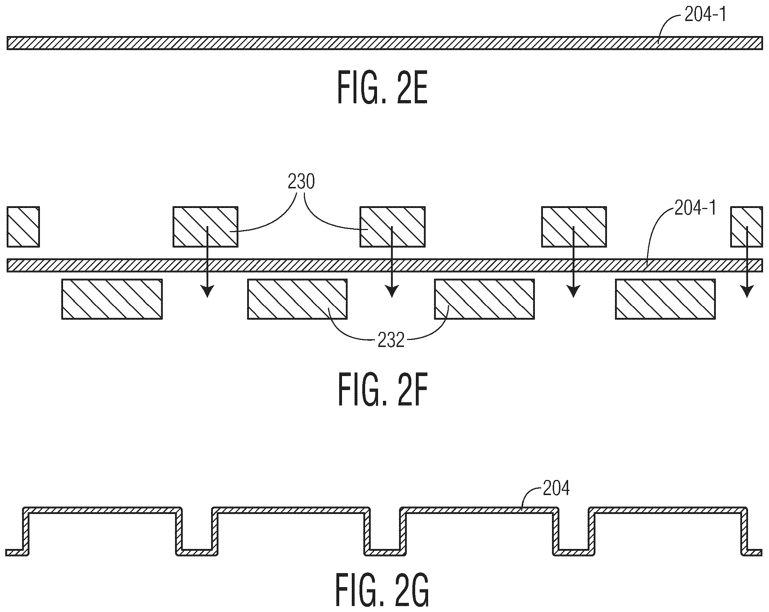

Next, a leadframe 204-1 is provided that will be used to form the bent leadframe 204 for each of the electronic packages being produced, as illustrated in Fig. 2E. The leadframe 204-1 can be any leadframe commonly used to package dies for various applications.

Next, the leadframe 204-1 is bent into a square wave shape to produce the bent leadframes 204 for the electronic packages, as illustrated in Fig. 2F. The leadframe 204-1 may be bent using any mechanical process, such as using a forming tool as an example. As illustrated, the forming tool may include movable teeth 230 that interfaces with stationary teeth 232 to bend the leadframe 204-1 in order to shape the leadframe 204-1 to conform to the batteries 202 that are attached to the leadframe 208. The resulting bent leadframe 204 is illustrated in Fig. 2G.

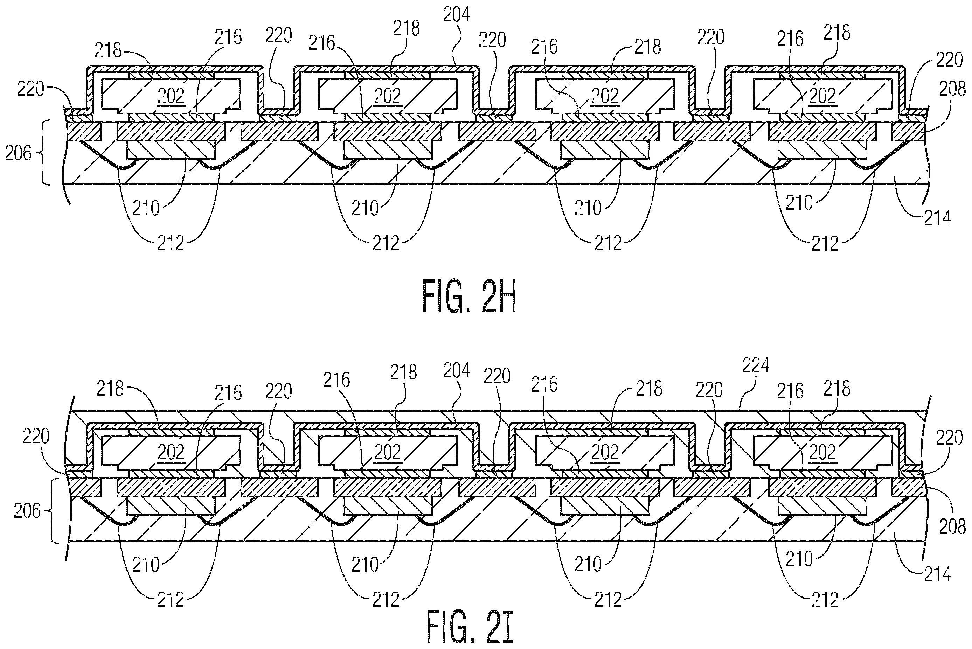

Next, the resulting bent leadframe 204 is physically attached to the batteries 202 and the leadframe 208 of the package structure 206 using the electrically conductive bonding materials 218 and 220, respectively, as illustrated in Fig. 2H. In one or more embodiments, the electrically conductive bonding materials 218 and 220 may be different bonding materials such that one bonding material may be used to attach the bent leadframe 204 to the batteries 202, and another bonding material may be used to attach the bent leadframe 204 to the leadframe 208. As an example, solder may be used to attach the bent leadframe 204 to the batteries 202 and ECA may be used to attach the bent leadframe 204 to the leadframe 208. Alternatively, ECA may be used to attach the bent leadframe 204 to the batteries 202 and solder may be used to attach the bent leadframe 204 to the leadframe 208. In other embodiments, the same bonding material may be used to attach the bent leadframe 204 to the batteries 202, and the bent leadframe 204 to the leadframe 208. As an example, solder may be used to attach the bent leadframe 204 to the batteries 202, and to attach the bent leadframe 204 to the leadframe 208. Alternatively, ECA may be used to attach the bent leadframe 204 to the batteries 202, and to attach the bent leadframe 204 to the leadframe 208. In one or more alternative embodiments, the bent leadframe 204 may be attached to the batteries 202 and/or the leadframe 208 using a welding process.

Next, the bent leadframe 204 and the batteries 202 are encapsulated using a potting material 224, as illustrated in Fig. 2I. In other embodiments, the bent leadframe 204 and the batteries 202 may be encapsulated using other suitable encapsulant material, such as conformal coatings or any other low temperature cure insulating materials.

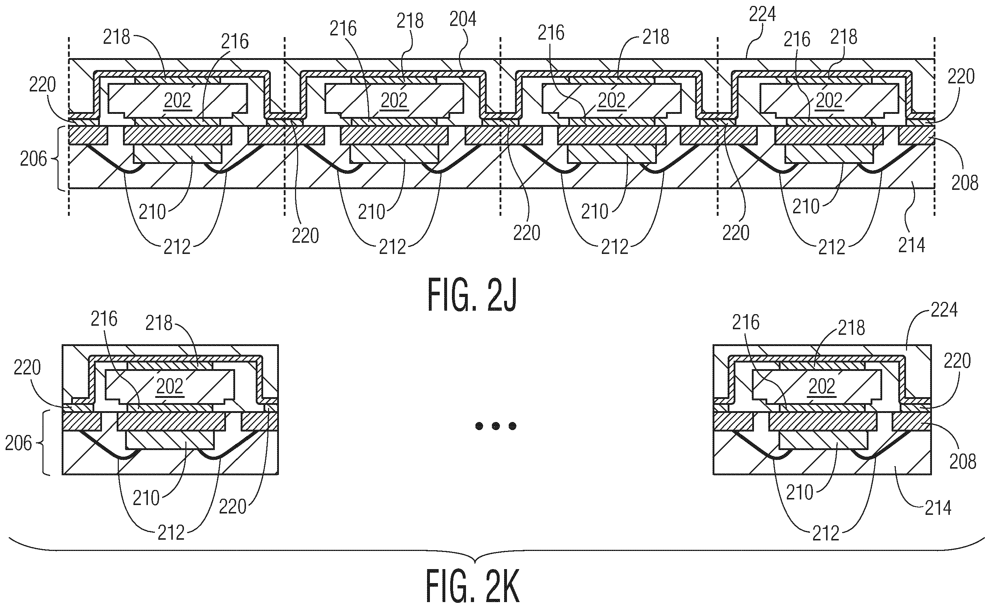

Next, the resulting package structure with the encapsulated bent leadframe 204 and the package structure 206 is then cut to separate the individual electronic packages, as illustrated in Fig. 2J, which shows dotted lines where the cuts are made in the package structure. The package structure may be cut using a mechanical singulation machine or a laser singulation machine. This singulation step results in the electronic packages, which are identical to the electronic package 100 of Fig. 1, as illustrated in Fig. 2K.

In the electronic package 100 of Fig. 1, the package structure 106 is a leadframe-based package on which the battery 102 and the bent leadframe 104 are attached. However, in other embodiments, different package structures may be used. Some examples of electronic packages using different package structures in accordance with embodiments of the invention are described below.

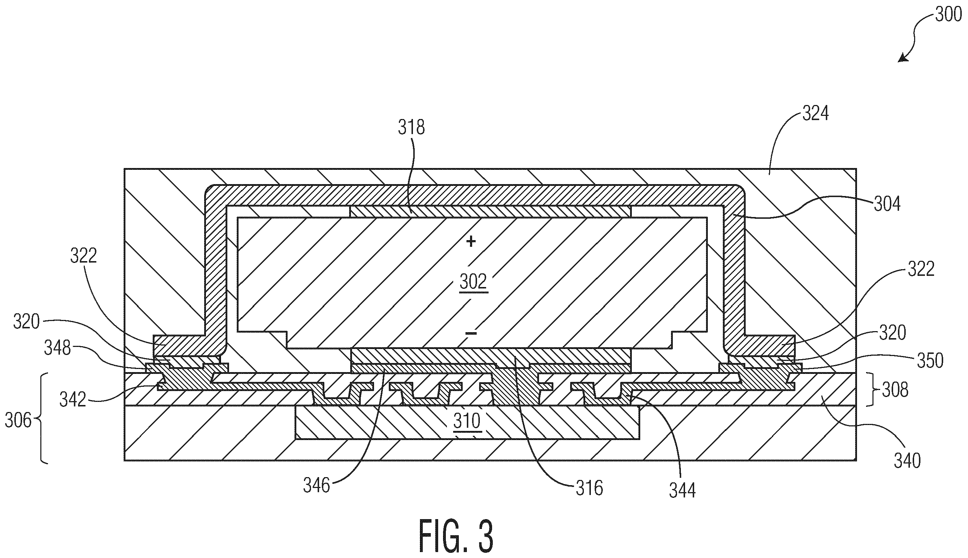

Turning now to Fig. 3, an electronic package 300 with a battery 302 that includes a package structure 306 in accordance with a different embodiment of the invention is shown. The package structure 306 of the electronic package 300 includes a die 310 that is attached to a substrate 308, which may be a printed circuit board (PCB). In one or more embodiments, the die 310 is attached to the substrate 308 faced down, i.e., the side of the die with input/output connections is facing the substrate. The substrate 308 includes one or more dielectric layers 340 and one or more metallization layers 342. The metallization layers 342 are electrically connected to each other through one or more interconnects 344. The substrate 308 further includes pads 346, 348 and 350, which are electrically connected to some of the metallization layers 342. The die 310 is attached to the substrate 308 such that the die 310 is electrically connected to at least some of the metallization layers 342. The die 310 is encapsulated by an encapsulant material, such as epoxy-based encapsulant. The package structure 306 may be fabricated by a process in which Silicon dies are diced and spaced apart using a resin material, and then the redistribution lines are built on top using metal and re-passivation layers that form the substrate 308. The described package structure can be referred to as a fan-out (FO) wafer-level chip scale package (WLCSP).

In this embodiment, the negative side of the battery 302 is attached to the pad 346 on the substrate 308 using an electrically conductive bonding material 316, such as a low temperature cure ECA or low temperature solder. The positive side of the battery 302 is physically attached to a bent leadframe 304 using another electrically conductive bonding material 318, which may be same or different from the electrically conductive bonding material 316.

The bent leadframe 304 is also attached to the pads 348 and 350 on the substrate 308 using at least one electrically conductive bonding material 320, such as a low temperature cure ECA or low temperature solder. As illustrated, the bent leadframe 304 may be similar in shape as the bent leadframe 104 of the electronic package 100 of Fig. 1. Thus, the bent leadframe 304 has flanged ends 322 that are used to attach the bent leadframe 304 to the substrate 308. The same or different electrically conductive bonding materials may be used to attach the two flanged ends 322 of the bent leadframe 304 to the substrate 308. In one or more alternative embodiments, the bent leadframe 304 may be attached to the battery 302 and/or the substrate 308 using a welding process.

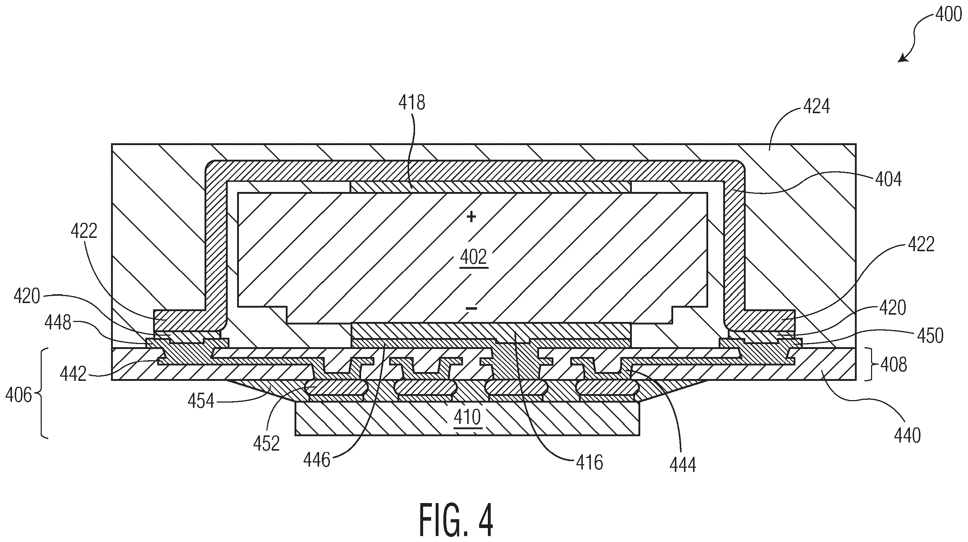

Turning now to Fig. 4, an electronic package 400 with a battery 402 that includes a package structure 406 in the form of a flip chip package in accordance with an embodiment of the invention is shown. The flip chip package structure 406 includes a die 410 that is attached to a substrate 408, which may be a printed circuit board (PCB), using a flip chip process. The substrate 408 is similar to the substrate 308 in the package structure 306. Thus, similar to the substrate 308, the 408 substrate includes one or more dielectric layers 440 and one or more metallization layers 442. The metallization layers 442 are electrically connected to each other through one or more interconnects 444. The substrate 408 further includes pads 446, 448 and 450, which are electrically connected to some of the metallization layers 442. The die 410 is attached to the substrate 408 using solder balls 452 such that the die 410 is electrically connected to at least some of the metallization layers 442. The interface between the die 410 and the substrate 408 is filled using an electrically insulating adhesive 454. In the illustrated embodiment, the die 410 is not encapsulated. However, in other embodiments, the die 410 may be encapsulated by an encapsulant material, such as epoxy-based encapsulant.

In this embodiment, the negative side of the battery 402 is attached to the pad 446 on the substrate 408 using an electrically conductive bonding material 416, such as a low temperature cure ECA or low temperature solder. The positive side of the battery 402 is physically attached to a bent leadframe 404 using another electrically conductive bonding material 418, which may be same or different from the electrically conductive bonding material 416.

The bent leadframe 404 is also attached to the pads 448 and 450 on the substrate 408 using at least one electrically conductive bonding material 420, such as a low temperature cure ECA or low temperature solder. As illustrated, the bent leadframe 404 may be similar in shape as the bent leadframe 104 of the electronic package 100 of Fig. 1. Thus, the bent leadframe 404 has flanged ends 422 that are used to attach the bent leadframe 404 to the substrate 408. The same or different electrically conductive bonding materials may be used to attach the two flanged ends 422 of the bent leadframe 404 to the substrate 408. In one or more alternative embodiments, the bent leadframe 404 may be attached to the battery 402 and/or the substrate 308 using a welding process.

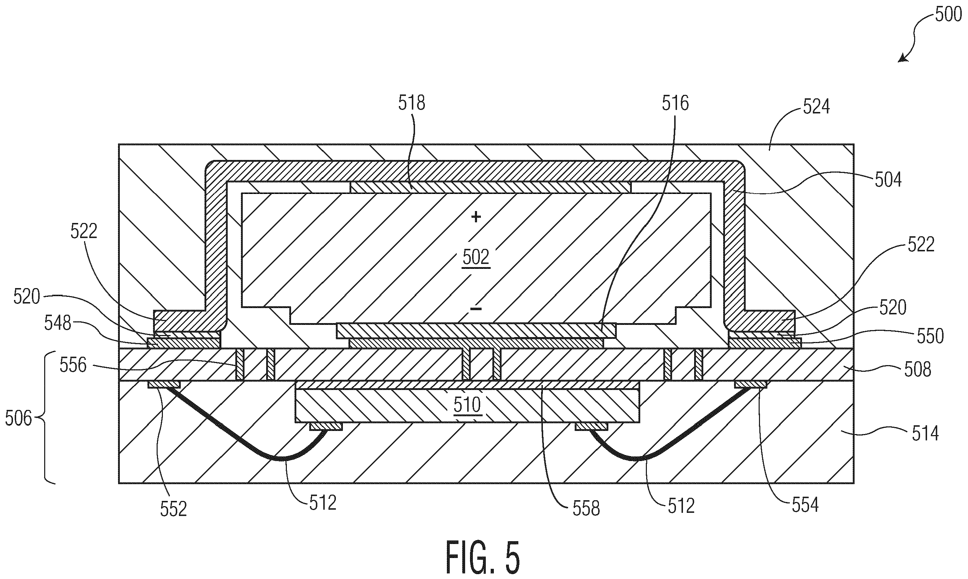

Turning now to Fig. 5, an electronic package 500 with a battery 502 that includes a package structure 506 in accordance with another embodiment of the invention is shown. The package structure 506 of the electronic package 500 includes a die 510 that is attached to a substrate 508 using an adhesive material, such as die attach epoxy. In one or more embodiments, the die 510 is attached to the substrate 508 faced up, i.e., the side of the die with the input/output connections is facing away from the substrate. The substrate 508 includes metal layers on a dielectric medium that form pads 546, 548, 550, 552 and 554. The metal layers are electrically connected to each other using routing vias 556. The die 510 is attached to the substrate 508 using a bonding material 558 such that the die 510 is electrically connected to the metal layers. As an example, a die attach adhesive or solder balls may be used to physically and electrically connect the die 510 to the substrate 508. The die 510 is also electrically connected to the substrate 508 using bondwires 512. The die 510 is encapsulated by an encapsulant material 514, such as epoxy-based encapsulant. However, in other embodiments, the die 510 may not be encapsulated. The described package structure can be referred to as a mold array process (MAP) ball grid array (BGA) package.

In this embodiment, the negative side of the battery 502 is attached to the pad 546 on the substrate 508 using an electrically conductive bonding material 516, such as a low temperature cure ECA or low temperature solder. The positive side of the battery 502 is physically attached to a bent leadframe 504 using another electrically conductive bonding material 518, which may be same or different from the electrically conductive bonding material 516.

The bent leadframe 504 is also attached to the pads 548 and 550 on the substrate 508 using at least one electrically conductive bonding material 520, such as a low temperature cure ECA or low temperature solder. As illustrated, the bent leadframe 504 may be similar in shape as the bent leadframe 104 of the electronic package 100 of Fig. 1. Thus, the bent leadframe 504 has flanged ends 522 that are used to attach the bent leadframe 504 to the substrate 508. The same or different electrically conductive bonding materials may be used to attach the two flanged ends 522 of the bent leadframe 504 to the substrate 508. In one or more alternative embodiments, the bent leadframe 504 may be attached to the battery 502 and/or the substrate 508 using a welding process.

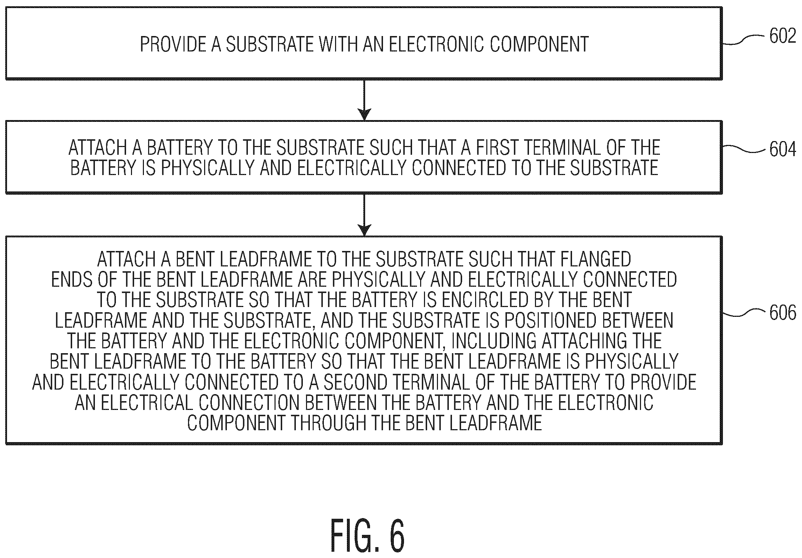

A method for producing an electronic package, such as the electronic packages 100, 300, 400 and 500, in accordance with an embodiment of the invention is described with reference to a flow diagram of Fig. 6. At block 602, a substrate with an electronic component is provided. At block 604, a battery is attached to the substrate such that a first terminal of the battery is physically and electrically connected to the substrate. At block 606, a bent leadframe is attached to the substrate such that flanged ends of the bent leadframe are physically and electrically connected to the substrate so that the battery is encircled by the bent leadframe and the substrate, and the substrate is positioned between the battery and the electronic component. In addition, the bent leadframe is attached to the battery so that the bent leadframe is physically and electrically connected to a second substrate of the battery to provide an electrical connection between the battery and the electronic component through the bent leadframe.

Although the step(s) of the method(s) herein are shown and described in a particular order, the order of the steps of each method may be altered so that certain steps may be performed in an inverse order or so that certain steps may be performed, at least in part, concurrently with other steps.

Although specific embodiments of the invention have been described and illustrated, the invention is not to be limited to the specific forms or arrangements of parts so described and illustrated. The scope of the invention is to be defined by the claims

## Claims

1. An electronic package comprising:
a substrate (108) with an electronic component (110);
a battery (102) having a second terminal that is physically and electrically connected to the substrate (108);
a bent leadframe (104) having flanged ends (122) that are physically and electrically connected to the substrate (108) so that the battery (102) is encircled by the bent leadframe (104) and the substrate (108) and the substrate (108) is positioned between the battery (102) and the electronic component (110), the bent leadframe (104) further being physically and electrically connected to a first terminal of the battery (102) to provide an electrical connection between the battery (102) and the electronic component (110) through the bent leadframe, (104) wherein the second terminal of the battery (102) is attached to the substrate (108) via a low cure electrically conductive adhesive (116);
and a low temperature cure potting material (124) encapsulating the bent leadframe (104) and the battery (102)

2. The electronic package of claim 1, wherein the first terminal of the battery is welded to the bent leadframe or attached to the bent leadframe using an electrically conductive adhesive or solder.

3. The electronic package of claim 2, wherein the first terminal of the battery is a positive terminal of the battery.

4. The electronic package of claim 1, wherein the second terminal of the battery is a negative terminal of the battery.

5. The electronic package of any preceding claim, wherein at least one of the flanged ends of the bent leadframe is welded to the substrate or attached to the substrate using an electrically conductive adhesive or solder.

6. The electronic package of any preceding claim, wherein the battery is a coin-type battery.

7. The electronic package of any preceding claim, wherein the substrate is a leadframe and wherein the electronic component is a die attached to a leadframe.

8. The electronic package of any preceding claim, wherein the electronic component is a die attached to the substrate.

9. The electronic package of claim 8, wherein the die is attached to the substrate faced down such that a side of the die with input and output connections is facing the substrate or faced up such that the side with the input and output connections of the die is facing away from the substrate.

10. A method for producing an electronic package, the method comprising:
providing a substrate (108) with an electronic component (110);
attaching a battery (102) to the substrate (108) such that a second terminal of the battery (102) is physically and electrically connected to the substrate (108);
attaching a bent leadframe (104) to the substrate (108) such that flanged ends (122) of the bent leadframe (104) are physically and electrically connected to the substrate (108) so that the battery (102) is encircled by the bent leadframe (104) and the substrate (108), and the substrate (108) is positioned between the battery (102) and the electronic component (110), including attaching the bent leadframe (104) to the battery (102) so that the bent leadframe (104) is physically and electrically connected to a first terminal of the battery (102) to provide an electrical connection between the battery (102) and the electronic component (110) through the bent leadframe, (104) wherein the second terminal of the battery (102) is attached to the substrate (108) via a low cure electrically conductive adhesive (116) and
encapsulating the bent leadframe (104) and the battery (102) using a low temperature cure potting material (124).

11. The method of claim 10, wherein the first terminal of the battery is welded to the bent leadframe or attached to the bent leadframe using an electrically conductive adhesive or solder.

12. The method of claim 10, wherein the first terminal of the battery is a positive terminal of the battery.

13. The method of claim 10, wherein the second terminal of the battery is a negative terminal of the battery.

## Patentansprüche

1. Elektronisches Gehäuse, das umfasst:
ein Substrat (108) mit einer elektronischen Komponente (110);
eine Batterie (102) mit einem zweiten Anschluss, der physisch und elektrisch mit dem Substrat (108) verbunden ist;
einen gebogenen Leiterrahmen (104) mit Flanschenden (122), die physisch und elektrisch mit dem Substrat (108) verbunden sind, sodass die Batterie (102) von dem gebogenen Leiterrahmen (104) und dem Substrat (108) umgeben ist und das Substrat (108) zwischen der Batterie (102) und der elektronischen Komponente (110) positioniert ist, wobei der gebogene Leiterrahmen (104) ferner physisch und elektrisch mit einem ersten Anschluss der Batterie (102) verbunden ist, um eine elektrische Verbindung zwischen der Batterie (102) und der elektronischen Komponente (110) durch den gebogenen Leiterrahmen (104) bereitzustellen, wobei der zweite Anschluss der Batterie (102) über einen elektrisch leitfähigen Klebstoff (116) mit niedriger Aushärtung an dem Substrat (108) befestigt ist;
und ein bei niedriger Temperatur aushärtendes Vergussmaterial (124), das den gebogenen Leiterrahmen (104) und die Batterie (102) einkapselt.

2. Elektronisches Gehäuse nach Anspruch 1, wobei der erste Anschluss der Batterie mit dem gebogenen Leiterrahmen verschweißt oder unter Verwendung eines elektrisch leitfähigen Klebstoffs oder Lots an dem gebogenen Leiterrahmen befestigt ist.

3. Elektronisches Gehäuse nach Anspruch 2, wobei der erste Anschluss der Batterie ein positiver Anschluss der Batterie ist.

4. Elektronisches Gehäuse nach Anspruch 1, wobei der zweite Anschluss der Batterie ein negativer Anschluss der Batterie ist.

5. Elektronisches Gehäuse nach einem der vorhergehenden Ansprüche, wobei mindestens eines der Flanschenden des gebogenen Leiterrahmens mit dem Substrat verschweißt oder unter Verwendung eines elektrisch leitfähigen Klebstoffs oder Lots an dem Substrat befestigt ist.

6. Elektronisches Gehäuse nach einem der vorhergehenden Ansprüche, wobei die Batterie eine Knopfbatterie ist.

7. Elektronisches Gehäuse nach einem der vorhergehenden Ansprüche, wobei das Substrat ein Leiterrahmen ist und wobei die elektronische Komponente ein Die ist, der an einem Leiterrahmen befestigt ist.

8. Elektronisches Gehäuse nach einem der vorhergehenden Ansprüche, wobei die elektronische Komponente ein Die ist, der an dem Substrat befestigt ist.

9. Elektronisches Gehäuse nach Anspruch 8, wobei der Die an dem Substrat nach unten gerichtet befestigt ist, sodass eine Seite des Die mit Eingangs- und Ausgangsverbindungen dem Substrat zugewandt ist oder nach oben gerichtet ist, sodass die Seite mit den Eingangs- und Ausgangsverbindungen des Die von dem Substrat weg gerichtet ist.

10. Verfahren zum Herstellen eines elektronischen Gehäuses, wobei das Verfahren umfasst:
Bereitstellen eines Substrats (108) mit einer elektronischen Komponente (110);
Befestigen einer Batterie (102) an dem Substrat (108), sodass ein zweiter Anschluss der Batterie (102) physisch und elektrisch mit dem Substrat (108) verbunden ist;
Befestigen eines gebogenen Leiterrahmens (104) an dem Substrat (108), sodass Flanschenden (122) des gebogenen Leiterrahmens (104) physisch und elektrisch mit dem Substrat (108) verbunden sind, sodass die Batterie (102) von dem gebogenen Leiterrahmen (104) und dem Substrat (108) umgeben ist und das Substrat (108) zwischen der Batterie (102) und der elektronischen Komponente (110) positioniert ist, einschließlich Befestigen des gebogenen Leiterrahmens (104) an der Batterie (102), sodass der gebogene Leiterrahmen (104) physisch und elektrisch mit einem ersten Anschluss der Batterie (102) verbunden ist, um eine elektrische Verbindung zwischen der Batterie (102) und der elektronischen Komponente (110) durch den gebogenen Leiterrahmen bereitzustellen (104), wobei der zweite Anschluss der Batterie (102) über einen elektrisch leitfähigen Klebstoff (116) mit niedriger Aushärtung an dem Substrat (108) befestigt ist und den gebogenen Leiterrahmen (104) und die Batterie (102) unter Verwendung eines Vergussmaterials (124) mit niedriger Aushärtung einkapselt.

11. Verfahren nach Anspruch 10, wobei der erste Anschluss der Batterie mit dem gebogenen Leiterrahmen verschweißt oder unter Verwendung eines elektrisch leitfähigen Klebstoffs oder Lots an dem gebogenen Leiterrahmen befestigt wird.

12. Verfahren nach Anspruch 10, wobei der erste Anschluss der Batterie ein positiver Anschluss der Batterie ist.

13. Verfahren nach Anspruch 10, wobei der zweite Anschluss der Batterie ein negativer Anschluss der Batterie ist.

## Revendications

1. Boîtier électronique, comprenant :
un substrat (108) avec un composant électronique (110) ;
une batterie (102) présentant une deuxième borne connectée physiquement et électriquement au substrat (108) ;
une grille de connexion courbée (104) ayant des extrémités à brides (122) qui sont connectées physiquement et électriquement au substrat (108) de sorte que la batterie (102) est entourée par la grille de connexion courbée (104) et le substrat (108) et le substrat (108) est positionné entre la batterie (102) et le composant électronique (110), la grille de connexion courbée (104) étant en outre connectée physiquement et électriquement à une première borne de la batterie (102) pour fournir une connexion électrique entre la batterie (102) et le composant électronique (110) par l'intermédiaire de la grille de connexion courbée (104), la deuxième borne de la batterie (102) étant fixée au substrat (108) via un adhésif électriquement conducteur à durcissement à basse température (116) ;
et un matériau de remplissage à durcissement à basse température (124) encapsulant la grille de connexion courbée (104) et la batterie (102).

2. Boîtier électronique selon la revendication 1, dans lequel la première borne de la batterie est soudée à la grille de connexion courbée ou fixée à la grille de connexion courbée en utilisant un adhésif ou une brasure électriquement conducteur/conductrice.

3. Boîtier électronique selon la revendication 2, dans lequel la première borne de la batterie est une borne positive de la batterie.

4. Boîtier électronique selon la revendication 1, dans lequel la deuxième borne de la batterie est une borne négative de la batterie.

5. Boîtier électronique selon l'une quelconque des revendications précédentes, dans lequel au moins une des extrémités à brides de la grille de connexion courbée est soudée au substrat ou fixée au substrat en utilisant un adhésif ou une brasure électriquement conducteur/conductrice.

6. Boîtier électronique selon l'une quelconque des revendications précédentes, dans lequel la batterie est une pile bouton.

7. Boîtier électronique selon l'une quelconque des revendications précédentes, dans lequel le substrat est une grille de connexion et dans lequel le composant électronique est un dé fixé à une grille de connexion.

8. Boîtier électronique selon l'une quelconque des revendications précédentes, dans lequel le composant électronique est une puce fixée au substrat.

9. Boîtier électronique selon la revendication 8, dans lequel la puce est fixée au substrat face vers le bas de telle sorte qu'un côté de la puce avec des connexions d'entrée et de sortie fait face au substrat ou est face vers le haut de telle sorte que le côté avec les connexions d'entrée et de sortie de la puce fait face vers l'opposé du substrat.

10. Procédé de réalisation d'un boîtier électronique, le procédé comprenant :
la fourniture d'un substrat (108) avec un composant électronique (110) ;
la fixation d'une batterie (102) au substrat (108) de telle sorte qu'une deuxième borne de la batterie (102) est connectée physiquement et électriquement au substrat (108) ;
la fixation d'une grille de connexion courbée (104) au substrat (108) de telle sorte que des extrémités à brides (122) de la grille de connexion courbée (104) sont connectées physiquement et électriquement au substrat (108) de sorte que la batterie (102) est entourée par la grille de connexion courbée (104) et le substrat (108), et que le substrat (108) est positionné entre la batterie (102) et le composant électronique (110), comportant la fixation de la grille de connexion courbée (104) à la batterie (102) de sorte que la grille de connexion courbée (104) est connectée physiquement et électriquement à une première borne de la batterie (102) pour fournir une connexion électrique entre la batterie (102) et le composant électronique (110) par l'intermédiaire de la grille de connexion courbée (104), la deuxième borne de la batterie (102) étant fixée au substrat (108) via un adhésif électriquement conducteur à durcissement à basse température (116) et encapsulant la grille de connexion courbée (104) et la batterie (102) en utilisant un matériau de remplissage à durcissement à basse température (124).

11. Procédé selon la revendication 10, dans lequel la première borne de la batterie est soudée à la grille de connexion courbée ou fixée à la grille de connexion courbée en utilisant un adhésif ou une brasure électriquement conducteur/conductrice.

12. Procédé selon la revendication 10, dans lequel la première borne de la batterie est une borne positive de la batterie.

13. Procédé selon la revendication 10, dans lequel la deuxième borne de la batterie est une borne négative de la batterie.
